# EUROPEAN PATENT APPLICATION

(11) **EP 1 061 043 A1**
(43) Date of publication of application: **20.12.2000**
(21) Application number: 00305079.6
(22) Date of filing: 15.06.2000
(51) Int. Cl.: C01B 31/02

(54) **Low-temperature synthesis of carbon nanotubes using metal catalyst layer for decomposing carbon source gas**

(30) Priority: 15.06.1999 KR 9922418; 02.06.2000 KR 0030353
(71) Applicant: Iljin Nanotech Co., Ltd., Seoul (KR); Lee, Cheol-jin, Gunsan-city, Jeonlabuk-do (KR)
(72) Inventor: Lee, Cheol-Jin, Gunsan-City, Jeonlabuk-do (KR); Yoo, Jae-Eun, Seongbuk-gu, Seoul (KR)
(74) Representative: Stuttard, Garry Philip

(57) **Abstract**

A low-temperature synthesis method of carbon nanotubes using a metal catalyst layer. In the synthesis method, a metal catalyst layer is formed over a substrate. The metal catalyst layer is etched to form isolated nano-sized catalytic metal particles. Then, carbon nanotubes vertically aligned over the substrate are grown from every isolated nano-sized catalytic metal particle through thermal chemical vapor deposition, by decomposing a carbon source gas at a temperature equal to or lower than the strain temperature of the substrate using a carbon source gas decomposing metal catalyst layer.

## Description

### BACKGROUND OF THE INVENTION

### 1. Field of the Invention

The present invention relates to a synthesis method of carbon nanotubes, and more particularly, to a mass low-temperature synthesis method of high purity carbon nanotubes vertically aligned over a large-sized substrate.

### 2. Description of the Related Art

Carbon nanotubes, which have conductivity in an arm-chair structure and semi-conductivity in a zig-zag structure, are applied as an electron emission source for field emission devices, white light sources, lithium secondary batteries, hydrogen storage cells, transistors and cathode ray tubes. For applications of carbon nanotubes in display devices, such as field emission displays (FEDs), it is essential to avoid strain of a substrate of display devices during synthesis of carbon nanotubes, and to grow high purity carbon nanotubes vertically aligned over a large area substrate. Also, it is another concern that the diameter and length of carbon nanotubes, and the density and uniformity over a substrate used can be easily adjusted for the carbon nanotube synthesis.

Existing carbon nanotube synthesis techniques include an arc discharge method, laser vaporization method, thermal chemical vapor deposition (CVD) and the like. The arc discharge method (C.Journet et al., *Nature*, 388, 756 (1997) and D.S. Bethune et al., *Nature*, 363, 605 (1993)) and the laser vaporization method (R.E.Smally et al., *Science*, 273, 483 (1996)) are not able to control the diameter or length of carbon nanotubes and the yield by these methods is low. Moreover, excess amorphous carbon lumps are also produced along with carbon nanotubes, and thus they need complicated purification processes. Thus, it has difficulty in growing carbon nanotubes over a large-sized substrate on a large production scale using these methods.

The thermal CVD method known to the art up to now involves growing carbon nanotubes over a porous silica (W.Z.Li et al., *Science*, 274, 1701 (1996)) or zeolite (Shinohara et al., *Japanese J. of Appl. Phys.*, 37, 1257 (1998)) substrate. However, filling pores of the substrate with a metal catalyst is a complicated and time consuming process. Moreover, the controlling of the diameter of carbon nanotubes is not easy, and the yield is low. Thus, the thermal CVD method has a limitation in growing massive carbon nanotubes over a relatively large substrate. Another drawback in the synthesis of carbon nanotubes by thermal CVD is that the synthesis is carried out at a high temperature of 700° C or more. Thus, it is impossible to apply the thermal CVD technique in the production of carbon nanotubes for various display devices that employ glass substrate made of, for example, tempered glass (having a strain temperature of 650°C or less), general glass (having a strain temperature of 570°C or less) or soda lime glass (having a strain temperature of 550° C or less). Use of glass substrate in the manufacture of display devices is inevitable in terms of technical and economical aspect, and thus for the synthesis of carbon nanotubes over such glass substrates, there is a need for a method of synthesizing carbon nanotubes at a temperature lower than the strain temperature of glass. In another aspect, since almost all existing developed electronic devices have electrical interconnections, almost of which are formed of aluminum having a melting point of 700° C or less, the conventional thermal CVD method performed at 700° C or more is not applicable in the manufacture of the electronic devices.

### SUMMARY OF THE INVENTION

To solve the above problems, it is an objective of the present invention to provide a mass low-temperature synthesis method of high purity carbon nanotubes vertically aligned over a large-sized substrate, which is performed at a temperature lower than the strain temperature of the substrate.

The objective of the present invention is achieved by a method of synthesizing carbon nanotubes, comprising forming a metal catalyst layer over a substrate. The metal catalyst layer is etched to form isolated nano-sized catalytic metal particles. Then, carbon nanotubes vertically aligned over the substrate are grown from every isolated nano-sized catalytic metal particle through thermal chemical vapor deposition, by decomposing a carbon source gas at a temperature equal to or lower than the strain temperature of the substrate using a carbon source gas decomposing metal catalyst layer.

Preferably, forming the isolated nano-sized catalytic metal particles is performed by a plasma etching method using plasma created using one gas selected from the group consisting of ammonia gas, hydrogen gas and hydride gas, or by a wet etching method using a hydrogen fluoride series etchant.

Preferably, the plasma etching is carried out at a temperature of 350 to 550°C.

Preferably, forming the carbon nanotubes comprises preparing a substrate having the carbon source gas decomposing metal catalyst layer. The substrate having the carbon source gas decomposing metal catalyst layer and the substrate having the isolated nano-sized catalytic metal particles are loaded into a thermal chemical vapor deposition apparatus, such that the surface of the carbon source gas decomposing metal catalyst layer and the surface of the isolated nano-sized catalytic metal particles face each other. Then, the carbon source gas is supplied into the thermal chemical vapor deposition apparatus, while maintaining the temperature of the thermal chemical vapor deposition apparatus at the temperature equal to or lower than the strain temperature of the substrate having the isolated nano-sized catalytic metal particles, to grow the number of carbon nanotubes from every isolated nano-sized catalytic metal particle, to be vertically aligned over the substrate.

### BRIEF DESCRIPTION OF THE DRAWINGS

The above objective and advantages of the present invention will become more apparent by describing in detail preferred embodiments thereof with reference to the attached drawings in which:
FIG. 1 is a flow chart illustrating a method of synthesizing carbon nanotubes according to a preferred embodiment of the present invention; and
FIGS. 2A and 2B are sectional views of a substrate having a metal catalyst layer served as a catalyst during synthesis of carbon nanotubes, and FIG. 2C is a sectional view of a substrate with a metal catalyst layer for decomposing carbon source gas;
FIG. 3 is a sectional view illustrating the formation of isolated nano-sized catalytic metal particles over a substrate;
FIG. 4 is a sectional view showing a boat of a thermal chemical vapor deposition (CVD) apparatus used in an embodiment of the present invention, and a number of substrates put into slits of the boat, including substrates having a metal catalyst layer for use in the decomposition of carbon source gas, and target substrates over which carbon nanotubes are to be grown;
FIG. 5 is a schematic view of a thermal CVD apparatus into which the boat of FIG. 4 is loaded, which is used in an embodiment of the present invention;
FIG. 6 is a sectional view illustrating the growing of carbon nanotubes from the isolated nano-sized catalytic metal particles; and
FIGS. 7A through 7C are schematic views illustrating a growth mechanism of carbon nanotubes from isolated catalytic metal particles.

### DETAILED DESCRIPTION OF THE INVENTION

The present invention will now be described more fully with reference to the accompanying drawings, in which preferred embodiments of the invention are shown. This invention may, however, be embodied in many different forms and should not be construed as being limited to the embodiments set forth herein. Rather, these embodiments are provided so that this disclosure will be thorough and complete, and will fully convey the concept of the invention to those skilled in the art. In the drawings, a thermal chemical vapor deposition (CVD) apparatus is simply illustrated for explanation. The thickness and proportions of a substrate, catalyst metal layer and catalytic metal particles are exaggerated for clarity. It is also noted that like reference numerals may be used to designate identical or corresponding parts throughout the drawings.

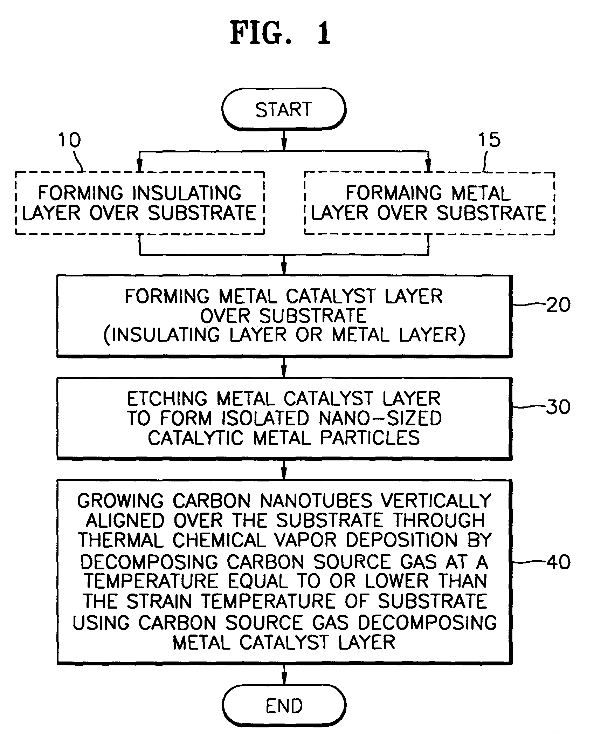

A low-temperature synthesis method of carbon nanotubes according to the present invention will be described with reference to FIG. 1. In the flowchart of FIG. 1, the essential steps for the synthesis are illustrated in solid-line boxes, while optional steps for the same are illustrated in dashed-line boxes.

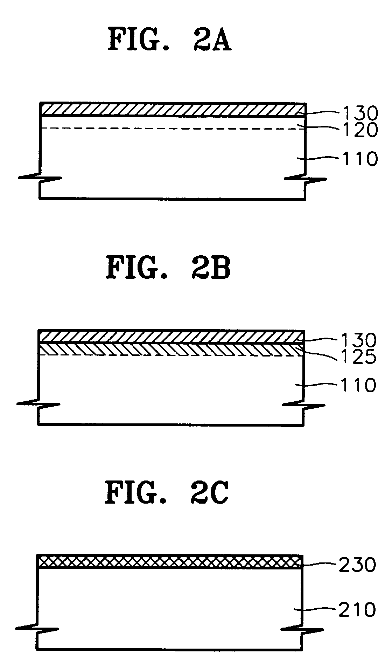

Referring to FIG. 1, a metal catalyst layer (130 of FIG. 2A) is formed over a substrate (110 of FIG. 2A) over which carbon nanotubes are to be grown. As the substrate (110 of FIG. 2A), a glass, quartz, silicon or alumina (Al₂O₃) substrate can be used. The metal catalyst layer 130 is formed of cobalt (Co), nickel (Ni), iron (Fe) or an alloy of the same (Co-Ni, Co-Fe or Ni-Fe). The metal catalyst layer 130 is formed over the substrate 110 to a thickness of a few nanometers to a few hundred nanometers, preferably, to a thickness of 2 to 100 nm, by thermal deposition, electron-beam deposition or sputtering.

In the case where the substrate 110 made of silicon is used and the metal catalyst layer 130 is formed of Co, Ni or an alloy of the same, an insulating layer (120 of FIG. 2B) is formed over the substrate 100 before the formation of the metal catalyst layer 130, which prevents generation of a suicide film by reaction between the metal catalyst layer 130 and the substrate 110 (step 10). A silicon oxide or alumina layer can be formed as the insulating layer 120.

For applications of carbon nanotubes in field emission devices (FEDs) or white light sources, as shown in FIG. 2B, it is preferable to form a metal layer 130 over the substrate 100 before the formation of the metal catalyst layer 130 (step 15). The metal layer 125 is formed of chromium (Cr), titanium (Ti), titanium nitride (TiN), tungsten (W) or aluminum (Al). The metal layer 125 can be used for electrodes for such devices as FEDs or while light sources.

On the other hand, another substrate 210 is prepared, and a metal catalyst layer 230 for decomposing carbon source gas is formed over the substrate 210. Preferably, the metal catalyst layer 230 for decomposing carbon source gas is formed of Cr or palladium (Pd). The metal catalyst layer 230 for decomposing carbon source gas may be formed to have a thickness of 100 to 200 nm.

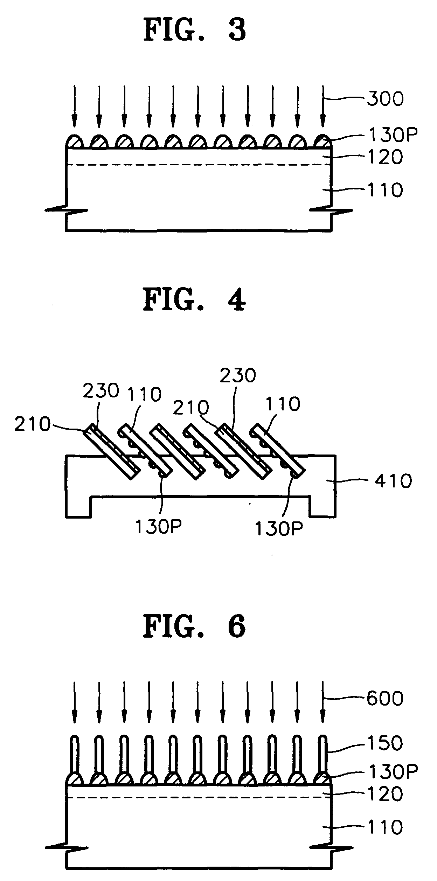

After step 20, the metal catalyst layer 130 is etched to form independently isolated nano-sized catalytic metal particles 130P, as shown in FIG. 3 (step 30). Use of a plasma etching or wet etching technique enables formation of catalytic metal particles at low temperatures.

The formation of catalytic metal particles by plasma etching is illustrated in FIG. 3. Referring to FIG. 3, as plasma 300 is supplied over the metal catalyst layer 130, the metal catalyst layer 130 is etched along grain boundaries to form independently isolated nano-sized catalytic metal particles 130P over the substrate 110 in high density with uniformity. The term "nano size" used in the specification refers to the size of a few nanometers to a few hundred nanometers. The size and shape of isolated nano-sized catalytic metal particles vary according to etching conditions. Also, the shape of catalytic metal particles affects the shape of carbon nanotubes produced in a subsequent process.

Plasma etching can be performed independently in a plasma etching apparatus or can be performed in a plasma etching apparatus combined with a thermal CVD apparatus to be used in subsequent formation of carbon nanotubes. The combination type system may be a multi-chamber system in which a plasma etching apparatus and a thermal CVD apparatus are assembled in a single cluster, or a combination of a remote plasma apparatus and a thermal CVD apparatus. The combination type system is preferred so as to reduce time consumed for the transfer of substrate and to prevent exposure of the substrate to contaminants in the air.

As for the independent plasma etching apparatus, a plasma is produced under the processing conditions of a frequency of 13.6 MHz, a gas pressure of 0.1 to 10 Torr, and power of 50 to 200 watts, by supplying ammonia gas, hydrogen gas or hydride gas to the reaction chamber at a flow rate of 30 to 150 sccm. Then, the metal catalyst layer formed over a substrate is etched with the plasma at a temperature equal to or lower than the strain temperature of the substrate used, i.e., at a temperature of 650° C or less, preferably, at a temperature of 350 to 550 °C for 5 to 2 minutes, to form isolated nano-sized catalytic metal particles.

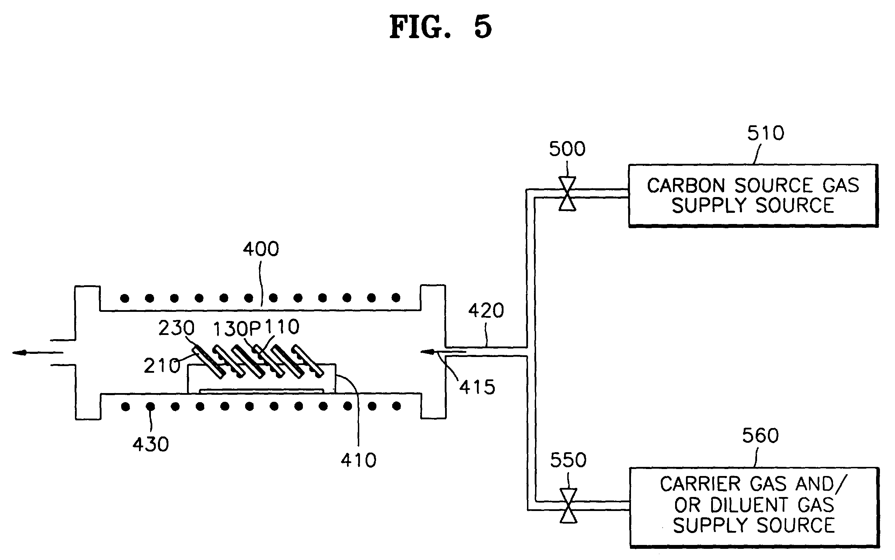

As for the combination type system including remote plasma apparatus and chemical CVD apparatus, a plasma is created by supplying ammonia gas, hydrogen gas or hydride gas at a flow rate of 30 to 150 sccm into the remote plasma apparatus with application of a frequency of 13.6 MHz, and then the produced plasma is supplied into the chemical CVD apparatus (see FIG. 5) to form isolated nano-sized catalytic metal particles. Here, the plasma etching is performed at a temperature of equal to or lower than the strain temperature of the substrate.

Preferably, plasma is generated with ammonia gas. Plasma etching is advantageous in that the metal catalyst layer can be etched into isolated nano-sized catalytic metal particles having a desired shape even at low temperatures, and the controlling of reaction is easy.

Meanwhile, in a wet etching method, a substrate having the metal catalyst layer is immersed in hydrogen fluoride (HF) series etchant, for example, HF solution or HF and NH₄F solution, for 1 to 5 minutes, to form isolated nano-sized catalytic metal particles. An advantage of the wet etching technique also lies in that it is performed at low temperatures.

As the last step, after step 30 of forming catalytic metal particles 130P over the substrate 110, carbon nanotubes are grown from the catalytic metal particles 130P by thermal CVD using the metal catalyst layer 230 for decomposing carbon source gas (step 40). The thermal CVD can be performed at a lower temperature than the strain temperature of the used substrate 110 by pyrolysis of carbon source gas due to the presence of the metal catalyst layer 230 for decomposing carbon source gas.

In particular, the substrates 110 over which carbon nanotubes are to be grown, each having the isolated nano-sized catalytic metal particles 130P, are positioned into slits of the boat 410 of a thermal CVD apparatus, one slit apart. Next, the empty slits of the boat 410 are filled with the substrates 210 each having the metal catalyst layer 230 for decomposing carbon source gas, such that the metal catalyst layers 230 of the substrates 210 face the isolated nano-sized catalytic metal particles 130P of the target substrates 110, as shown in FIG. 4.

The boat 410 holding the substrates 110 and 210 is loaded into a furnace 400 of the thermal CVD apparatus shown in FIG. 5. Here, the boat 410 is loaded such that the surface of the catalytic metal particles 130P formed over the substrates 110 faces downward in the opposite direction to the flow of carbon source gas, indicated by arrow 415, while the surface of the metal catalyst layers 230 formed over the substrates 210 faces the flow 415 of carbon source gas, as show in FIG. 5. The reason why the substrates 110 are arranged such that the surface of the catalytic metal particles 130P faces the opposite direction to the flow of carbon source gas is so that a uniform reaction over the substrates 110 coated by the catalytic metal particles 130P may be achieved by evenly controlling the mass flow of carbon source gas. Also, the insertion of the substrates 110 into the boat 410 such that the surface of the catalytic metal particles 130P faces downwards is to prevent defects due to unstable reaction products, or carbon particles falling down from the wall of the reaction furnace 400.

When the temperature of the reaction furnace 400 reaches a predetermined processing temperature, a first valve 500 is opened to allow a carbon source gas from a carbon source gas supply source 510 to flow into the reaction furnace 400 through a gas inlet 420. The carbon source gas is supplied at a flow rate of 20 to 80 sccm for 10 to 40 minutes. As the carbon source gas, hydrocarbon gas having 1 to 3 carbon atoms is used. Preferably, the carbon source gas comprises acetylene, ethylene, propylene, propane or methane gas.

To adjust the growth rate and time of carbon nanotubes, a second valve 550 is opened to supply a carrier gas (inert gas such as hydrogen or argon gas) and/or a diluent gas (hydride gas) from a carrier gas and/or diluent gas supply source 560 into the reaction furnace 400 along with the carbon source gas.

Although not shown, the carbon source gas can be supplied along with an etching gas (ammonia gas, hydrogen gas or hydride gas) in a predetermined ratio, which prevents undesirable adhesion of adjacent carbon nanotubes being formed over the substrate. It is preferably that the carbon source gas and the etching gas are supplied in a ratio of 2:1 to 3:1 by volume.

The carbon source gas introduced into the reaction furnace 400 of the thermal CVD apparatus contacts the metal catalyst layer 230 for decomposing carbon source gas, and is easily pyrolized at a temperature equal to or lower than the strain temperature of the substrate 110, where carbon nanotubes are to be formed, for example, at a temperature of 400 to 650° C equal to or lower than the strain temperature of glass, by the catalytic function of the metal catalyst layer 230.

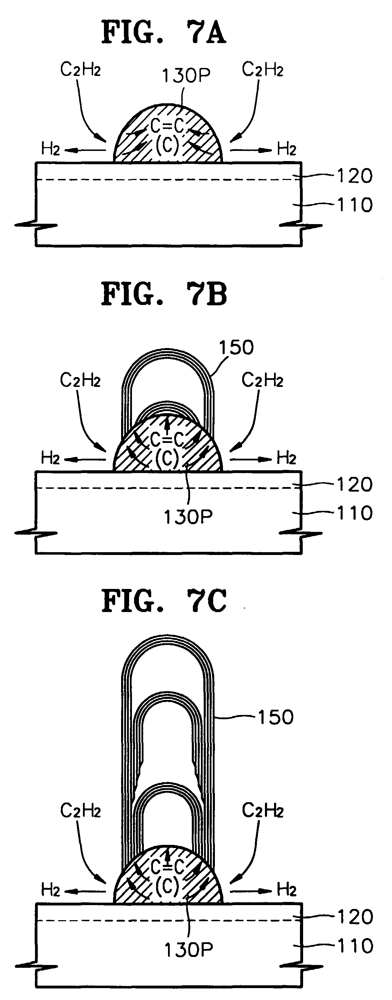

As shown in FIG. 6, the carbon source gas 600 pyrolized by the catalytic function of the metal catalyst layer 230 grows carbon nanotubes 150 from each of the isolated nano-sized catalytic metal particles 130P.

FIGS. 7A through 7C are schematic views of a base growth model. A growth mechanism will be described with reference to FIGS. 7A through 7C. First, as shown in FIG. 7A, a carbon source gas (for example, acetylene gas (C₂H₂)) supplied into the reaction furnace 400 of the thermal CVD system is pyrolized in a gas phase into carbon units (C=C or C). The carbon units adsorb onto the surface of the catalytic metal particles 130P and diffuse into the catalytic metal particles 130P. When the catalytic metal particles 130P are supersaturated with the dissolved carbon units, growth of carbon nanotubes 150 is initiated, as shown in FIG. 7B. As the intrusion of the carbon units into the catalytic metal particles 130P is continued, the carbon nanotubes 150 grow, like a bamboo, as shown in FIG. 7C, by the catalytic function of the catalytic metal particles 130P. If the catalytic metal particles 130P have round or blunt tips, the carbon nanotubes 150 are grown with round or blunt tips. Although not illustrated, if nano-sized metal catalytic particles 130P have sharp tips, carbon nanotubes are grown to have sharp tips.

Although the present embodiment is described with reference to a horizontal type thermal (CVD) apparatus, it is appreciated that a vertical type, in-line type or conveyer type CVD apparatus can be employed.

The present embodiment of the carbon nanotube synthesis method according to the present invention can produce carbon nanotubes having a diameter of a few nanometers to a few hundred nanometers, for example, 1 to 400 nm, and a length of a few micrometers to a few hundred micrometers, for example, 0.5 to 300 µm.

The present invention will be described in greater detail by means of the following experimental example. The following experimental example is for illustrative purposes and not intended to limit the scope of the invention.

### 〈Experimental Example〉

A nickel (Ni) film was formed over a glass substrate having a size of 2 cm by 3 cm, to a thickness of 100 nm by thermal deposition. Such glass substrates each having the Ni film were loaded into a plasma etching apparatus, and ammonia gas was supplied at a flow rate of 60 sccm into the plasma etching system to create a plasma, under the processing conditions of a frequency of 13.6 MHz, a gas pressure of 0.2 Torr and a power of 40 to 200 watts. The Ni film formed over the substrates was etched with the plasma at a temperature of 500°C to form isolated nano-sized catalytic Ni particles.

Meanwhile, a chromium (Cr) film was formed over another glass substrates to a thickness of 200 nm by thermal deposition.

The target substrates with isolated Ni particles, where carbon nanotubes were to be grown, were positioned into slits of a boat of a thermal CVD system, one slit apart, and the empty slits of the boat were filled with the substrates having the Cr film, such that the surface of the Ni film faced the Ni particles formed over the target substrates.

After loading the boat into the thermal CVD apparatus, the temperature of a reaction furnace was raised to 550° C while maintaining the pressure of the reaction furnace at 760 Torr. Following this, acetylene gas was supplied into the reaction furnace at a flow rate of 40 sccm for 10 minutes, to grow carbon nanotubes from each of the Ni particles. Scanning electron microscopy (SEM) shows that carbon nanotubes are vertically and uniformly grown over the substrate. The results of transmission electron microscopy (TEM) show that the obtained carbon nanotubes have a diameter of about 60 nm and a length of about 10 µm.

In the synthesis method of carbon nanotubes according to the present invention, the temperature of synthesis process can be lowered by the function of the metal catalyst layer that is able to decompose carbon source gas. As a result, the carbon nanotube synthesis can be carried out over a substrate for various display devices, for example, at a temperature equal to or lower than the strain temperature of glass substrate used. Thus, the inventive method is effectively applicable to the formation of a variety of display devices including FEDs.

Also, independently isolated nano-size catalytic metal particles can be uniformly formed over a substrate with high density, by etching a metal catalyst layer formed over the substrate. In other words, catalytic metal particles, which are suitable for growth of carbon nanotubes, can be formed isolated from each other, without agglomerating, and thus high purity uniform carbon nanotubes can be uniformly and vertically aligned over the substrate, without generation of amorphous carbon lumps. Moreover, in the case of using a larger substrate, carbon nanotubes can be evenly synthesized over the large substrate with high density.

In addition, the size of catalytic metal particles can be easily varied by adjusting the conditions of plasma etching for the formation of isolated nano-size catalytic metal particles, for example, plasma density, and etching temperature and time, and thus the diameter of carbon nanotubes can be easily adjusted. Furthermore, the length of carbon nanotubes can be easily varied by changing the supply conditions of carbon source gas, for example, flow rate, and reaction temperature and time. The inventive carbon nanotube synthesis method using a thermal CVD apparatus can be applied to batch type synthesis in which carbon nanotubes are grown simultaneously over a number of substrates with improved yield.

While this invention has been particularly shown and described with reference to preferred embodiments thereof, it will be understood by those skilled in the art that various changes in form and details may be made thereto without departing from the spirit and scope of the invention as defined by the appended claims.

## Claims

1. A method of synthesizing carbon nanotubes comprising:
forming a metal catalyst layer over a substrate;
etching the metal catalyst layer to form isolated nano-sized catalytic metal particles; and
growing carbon nanotubes vertically aligned over the substrate from every isolated nano-sized catalytic metal particle through thermal chemical vapor deposition, by decomposing a carbon source gas at a temperature equal to or lower than the strain temperature of the substrate using a carbon source gas decomposing metal catalyst layer.

2. A method as claimed in claim 1 wherein the metal catalyst layer is formed of cobalt, nickel, iron or an alloy of the same.

3. A method as claimed in claim 1 or 2 wherein forming the isolated nano-sized catalytic metal particles is performed by a plasma etching method using plasma created using one gas selected from the group consisting of ammonia gas, hydrogen gas and hydride gas.

4. A method as claimed in any preceding claim wherein the plasma etching is carried out at a temperature in the range 350 to 550°C.

5. A method as claimed in claim 1 wherein forming the isolated nano-sized catalytic metal particles is performed by a wet etching method using a hydrogen fluoride series etchant.

6. A method as claimed in any preceding claim wherein the temperature equal to or lower than the strain temperature of the substrate is in the range 400 to 650°C.

7. A method as claimed in claim 1 wherein forming the carbon nanotubes comprises:
preparing a substrate having the carbon source gas decomposing metal catalyst layer;
loading the substrate having the carbon source gas decomposing metal catalyst layer and the substrate having the isolated nano-sized catalytic metal particles into a thermal chemical vapour deposition apparatus such that the surface of the carbon source gas decomposing metal catalyst layer and the surface of the isolated nano-sized catalytic metal particles face each other; and
whilst maintaining the temperature of the thermal chemical vapour deposition apparatus at the temperature equal to or lower than the strain temperature of the substrate having the isolated nano-sized catalytic metal particles, supplying the carbon source gas into the thermal chemical vapor deposition apparatus to grow the number of carbon nanotubes from every isolated nano-sized catalytic metal particle to be vertically aligned over the substrate.

8. A method as claimed in any preceding claim further comprising before forming the metal catalyst layer, forming an insulating layer over the substrate to prevent reaction between the substrate and the metal catalyst layer.

9. A method as claimed in any preceding claim further comprising before forming the metal catalyst layer, forming a metal layer for electrodes over the substrate.
